# EUROPÄISCHE PATENTSCHRIFT

(11) **EP 2 053 649 B1**
(45) Veröffentlichungstag und Bekanntmachung des Hinweises auf die Patenterteilung: **08.06.2016**
(21) Anmeldenummer: 08167026.7
(22) Anmeldetag: 20.10.2008
(51) Int. Cl.: H01L 21/677, C23C 16/458

(54) **Vakuum-Durchlaufanlage zur Prozessierung von Substraten**
Vacuum continuous line to process substrates
Dispositif de passage sous vide destiné au traitement de substrats

(30) Priorität: 22.10.2007 DE 102007050699; 15.04.2008 DE 102008019023
(43) Veröffentlichungstag der Anmeldung: 29.04.2009
(73) Patentinhaber: Centrotherm Photovoltaics AG, 89143 Blaubeuren (DE)
(72) Erfinder: Dahl, Roland, 78465, Dettingen (DE); Haase, Josef, 89608, Griesingen (DE); Heintze, Dr. Moritz, 89073, Ulm (DE); Pernau, Dr. Thomas, 89143, Blaubeuren-Weiler (DE); Reichart, Hans, 89143, Blaubeuren (DE); Wanka, Dr. Harald, 89134, Blaustein (DE); Kähler, Dr. Jan-Dirk, 30900, Wedemark (DE); Lenz, Reinhard, 89143, Blaubeuren (DE); Zernickel, Dieter, 73340, Amstetten (DE); Hartung, Robert Michael, 89143, Blaubeuren (DE)
(74) Vertreter: Heyerhoff Geiger & Partner Patentanwälte PartGmbB

(56) Entgegenhaltungen:
- EP-A1- 1 622 192
- WO-A1-02/20871
- US-A- 6 066 210
- US-A1- 2002 021 952
- US-A1- 2002 080 291
- US-A1- 2005 006 230
- US-B1- 6 742 977

## Beschreibung

Die Erfindung betrifft eine Vakuum-Durchlaufanlage zur Prozessierung von Substraten mit einer Eintritts- und einer Austrittsschleuse, mindestens einer Prozesskammer sowie einer Einrichtung zum Transport der Substrate durch die Durchlaufanlage.

Der Markt verlangt nach Produktionsanlagen die den Anforderungen zur Integration in Fertigungslinien gerecht werden. Dies bedeutet u. a., dass die Leistungsfähigkeit der Produktionsanlage mit der Leistungsfähigkeit der Fertigungslinie synchronisiert werden muss. Die Produktionsanlage muss dazu an erster Stelle den Durchsatz der Fertigungslinie abbilden.

Da am Markt unterschiedlichste Durchsätze in Fertigungslinien üblich sind, muss ein Anlagenkonzept zur Verfügung stehen, welches unterschiedliche Durchsätze ermöglicht, und zwar derart, dass die Kompaktheit der Anlage für alle Durchsätze gewahrt bleibt, und dabei die Anlagenkosten pro Durchsatz-Einheit für alle Durchsatzvarianten konstant bleiben.

Zur Maximierung des Durchsatzes einer Vakuum-Durchlaufanlage müssen neben der eigentlichen Prozesszeit auch die Totzeiten, also der Zeitbedarf für Transport, Öffnen und Schließen der Vakuumschieber, usw., minimiert werden. Der Durchsatz kann nach Optimierung dieser Totzeiten nur durch Erhöhung der Kapazität des Substratträgers gesteigert werden.

Problematisch bei den üblichen Durchlaufanlagen ist die geringe bzw. beschränkte Kapazität des Substratträgers. Trotz des raumgreifenden Designs eines Substratträgers entsprechend dem Stand der Technik (ca. 1 bis 1,5 m breit und bis zu 1,8 m lang) ist das Fassungsvermögen für übliche Substrate der Größe 156x156 mm doch eher gering und liegt bei etwa 80 Stück.

Großflächige Substratträger erfordern eine große und daher teure Vakuumanlage zur Prozessierung bei niedrigem Druck. Besonders der Aufwand für das Ein- und Ausschleusen der Substratträger steigt mit deren Größe, so dass dem mit vertretbarem Aufwand erreichbaren Durchsatz eine Grenze gesetzt ist.

Durchlaufanlagen mit flachen Substratträgern erfordern bei einem Durchsatz ab 3000 Substraten pro Stunde eine Anlagengröße, die sich nicht gut in Fertigungsstraßen integrieren lässt und bei Be- und Entladung, als auch bei der Wartung einen unverhältnismäßig hohen Aufwand erfordert.

Ein großflächiger Substratträger führt zudem zu Problemen bei der Beladung, da für einige Substrate der Weg von der Aufnahme des Substrats bis zum Ablegen auf dem Substratträger sehr groß wird. Zudem sind die zentralen Substratpositionen auf dem Substratträger für die manuelle Beladung durch das Bedienpersonal nur sehr schwer zu erreichen. Die problematische Beladung resultiert schließlich in einer erhöhten Bruchrate.

Im Stand der Technik werden zur Anti-Reflex-Beschichtung von Solarzellen üblicherweise flache/ebene Substratträger eingesetzt, bei denen die Substrate in einer Ebene in Reihen und Spalten angeordnet sind. Ein typischer Substratträger hat dabei eine Größe von 1,0 x 1,8 m mit einer Dicke von etwa 1 cm. Das Reaktionsplasma brennt nicht direkt oberhalb oder neben den Substraten, wodurch sich ein Verlust an Plasma aktivierten Reaktanden auf der Wegstrecke zwischen Plasma und Substrat ergibt.

Bekannt sind auch Durchlaufanlagen zur Anti-Reflex-Beschichtung von Solarzellen, bei denen ebenfalls ebene Substratträger eingesetzt werden, wobei die Substrate in einer Ebene in Reihen und Spalten angeordnet sein können. Ein typischer Substratträger haz dabei eine Größe von 1,2 x 1,6 m, mit einer Dicke von etwa 1 cm.

Bei den Remote-Plasma Durchlaufanlagen entsprechend dem Stand der Technik werden somit flache Substratträger durch die Anlage gefahren, bei denen die Substrate in 2-dimensionaler Art in einer Ebene angeordnet sind.

Aus der DE 199 62 896 ist eine Vorrichtung zur Herstellung von Solarzellen nach einem kombinierten remote Plasma/LPCVD Verfahren bekannt. Diese Vorrichtung verfügt über ein langgestrecktes Prozessrohr aus Quarzglas, welches ein- und ausgangsseitig mit Vorkammern versehen ist, die groß genug sind, um je einen Waferträger aus Quarz mit einer Vielzahl von stehenden Wafern aus Silizium zu schleusen. Die Wafer stehen hier senkrecht, wodurch sich eine deutliche Platzersparnis bzw. Produktivitätssteigerung der Anlage erzielen lässt. Die erforderlichen Prozessschritte (Einschleusen, Substrate Aufheizen, Vorplasma, Beschichten, Abkühlen etc.) erfolgen dabei nacheinander an verschiedenen Positionen im Prozesskanal, wobei die Quarz-Waferträger schrittweise durch den Prozesskanal transportiert werden. Diese Waferträger sind jedoch vergleichsweise klein und nicht für den Betrieb mit der Direkt-Plasma-Technik geeignet, die eine Plasmaentladung direkt oberhalb der Substratoberfläche erfordert.

WO02/2087 A1 betrifft ein Plasmaboot zur Aufnahme von plattenförmigen Substraten und zur Behandlung derselben in einer Bearbeitungseinrichtung, wie z.B. einer Plasma-CVD-Anlage (PECVD), mit einer Vielzahl zueinander paralleler Aufnahmeplatten, wobei die Aufnahmeplatten gegeneinander isoliert wechselweise mit den Ausgängen eines Hochfrequenz-Generators (HF-Generator) verbunden sind, US2002/021952 A1 und EP1622192 A1 offenbaren Trägerplatten, auf denen Substrate zum Transport und zu einer Prozessierung in einer Anlage angeordnet sind.

Direkt-Plasma-CVD-Anlagen sind zum Prozessieren von Wafern in elektrisch leitfähigen Waferträgern in Form von Plasmabooten vorgesehen, die eine direkte Plasmaentladung oberhalb der Waferoberfläche ermöglichen. Das Prozessieren der Plasmaboote erfolgt im Chargenbetrieb, d.h. die Prozesskammer verfügt nur über eine einzige Hauptöffnung durch welche die Plasmaboote sowohl ein- als auch ausgefahren werden. Unter vermindertem Druck (üblicherweise 0,5 bis 5 mbar) und erhöhter Temperatur (üblicherweise 300 - 600°C) wird das Plasmaboot in der PECVD-Anlage (Plasma Enhanced Chemical Vapor Deposition) mit den zu beschichtenden Substraten/Wafern einer Atmosphäre von reaktiven Gasen ausgesetzt und durch Einspeisen einer Mittelfrequenzleistung ein Plasma zwischen den Substrathalteplatten des Plasmabootes erzeugt. Dazu muss das Plasmaboot sicher kontaktiert werden, was den Transport in einer Durchlaufanlage deutlich erschweren würde. Durch Änderung von Temperatur, Druck, Frequenz, Mischungsverhältnis der Gase, eingespeister elektrischer Leistung können die Eigenschaften der erzeugten Schicht vielfältig beeinflusst werden. Bei dieser Direkt-Plasma Technik ergeben sich keine Verluste von Plasma aktivierten Reaktanden auf dem Weg zwischen Aktivierungsort und Abscheideort.

Aufgabe der vorliegenden Erfindung ist die Schaffung einer Vakuum-Durchlaufanlage mit kompaktem Aufbau und hohem Durchsatz zur Plasma unterstützten Behandlung von Substraten mittels Direkt-Plasma Technik bei erniedrigtem Druck, die bei hoher Kapazität des Substratträgers eine einfache, schnelle und sichere Handhabung der Substrate gewährleistet.

Die Aufgabenstellung wird gemäß dem Gegenstand des unabhängigen Anspruchs 1 gelöst. Die Einrichtung zum Transport der Substrate durch die Durchlaufanlage hindurch weist mindestens ein Plasmaboot auf, bei dem die Substrate in dreidimensionaler Stapelung in mindestens einer Ebene in einem vorgegebenen Abstand zueinander unter Zwischenlage von Zwischenträgern auf einer Grundplatte angeordnet sind, wobei zumindest die Zwischenträger aus Grafit bestehen und über elektrische Verbindungsmittel mit einer Wechselspannung beaufschlagbar sind.

Ein Kennzeichen der Erfindung ist, dass die dritte Dimension für die Bestückung der Plasmaboote mit Substraten mit hinzugezogen wird. In einer Durchlaufanlage werden kompakte dreidimensionale Substratträger eingesetzt, bei denen die Substrate in einer oder mehreren Ebenen in geringem Abstand in waagerechter Stapelanordnung oder in senkrechter Anordnung stehend nebeneinander und/oder übereinander angeordnet sind. Die Substrate werden somit stapelweise in der Anlage prozessiert bzw. durch die Anlage gefahren, was die Kapazität beträchtlich erhöht.

Die Substrate können auch in mindestens zwei Reihen nebeneinander auf der Grundplatte bzw. gleichermaßen in jeder Ebene angeordnet werden, wobei die Grundfläche der Grundplatte bzw. der Zwischenplatten 1m x 0,2 m beträgt. Selbstverständlich können entsprechend den örtlichen Gegebenheiten bzw. Substratgrößen auch andere Abmessungen gewählt werden.

In einer weiteren Fortführung der Erfindung ist vorgesehen, dass der vorgegebene Abstand der Substrate in der Stapelanordnung zwischen 3-20 mm beträgt.

In einer Variante der Erfindung sind die Substrate beidseits an fest auf der Grundplatte stehenden Zwischenplatten befestigt und zwar derart, dass immer zwei Substrate einander gegenüber stehen. Die Befestigung der Substrate kann hier durch jeweils drei beidseits aus der Zwischenplatte hervorstehende und in einem Dreieck angeordnete pilzartige Pins erfolgen, wobei die Substrate hinter den pilzartigen Verdickungen räumlich fixiert sind.

In einer besonderen Ausgestaltung sind in einer Transportspur mindestens zwei Plasmaboote neben und/oder übereinander durch den Durchlaufofen fahrbar. Zu diesem Zweck sind die Grundplatten mit Gleitkufen, oder im Interesse einer geringeren Reibung, mit Rollen ausgestattet.

In einer besonderen Variante ist dass Plasmaboot in einem Transportrahmen fixiert, der aus miteinander verbundenen Längs- und Querholmen besteht, wobei die Längsholme des Transportrahmens auf der Unterseite mit regelmäßigen Vertiefungen bzw. Zähnen ausgestattet sind, in die Zahnräder zum horizontalen Transport des Transportrahmens mit dem darin gehalterten Graphitboot eingreifen. Bei dieser Variante kann der Transportrahmen, der einem gewissen Verschleiß unterliegt, leicht ausgetauscht werden.

Der Transportrahmen umschießt das Graphitboot außen formschlüssig, derart, dass das Graphitboot auf in den Eckbereichen des Transportrahmens befindliche Bootsauflagen aufsetzbar ist.

Schließlich sind die Bootsauflagen gegenüber dem Transportrahmen elektrisch isoliert ausgeführt.

Um in den Prozesskammern ein gleichmäßiges Plasma insbesondere nahe der Substrate auszubilden, ist in einer besonderen Fortführung der Erfindung jede zweite Zwischenplatte zu einem vordefinierten Punkt am Fuß des Plasmabootes durchgeführt und kontaktiert, eine erste Antennenanordnung bildend, und die dazwischen liegenden Zwischenplatten jeweils zu einem weiteren vordefinierten Punkt am Fuß des Bootes durchgeführt und kontaktiert, eine zweite Antennenanordnung bildend, und über die elektrischen Verbindungsmittel mit Zuführungen für Wechselspannung zur Ausbildung eines Plasmas zwischen der ersten und der zweiten Antennenanordnung verbunden.

Die elektrischen Verbindungsmittel können in Form von männlichen HF-Kontaktsteckern ausgebildet sein, welche zumindest die Zwischenplatten alternierend kontaktieren.

Die Kontaktstecker sind mittels eines Stellantriebes in die Kontaktposition mit den jeweiligen Kontaktpunkten am Fuß des Bootes und zurück fahrbar.

Schließlich kann vorgesehen sein, dass die Einrichtung zum Transport der Substrate durch die Durchlaufanlage hindurch eine Mehrzahl von zueinander parallel verlaufenden Transportspuren zum gleichzeitigen parallelen Transport mehrerer Plasmaboote umfasst, wobei sich die Transportspuren kanalförmig durch die Durchlaufanlage erstrecken.

Die Substratträger wurden erfindungsgemäß zur Steigerung der Kapazität in der Höhe erweitert, d.h. die dritte Dimension wird zur Kapazitätserweiterung ausgenutzt. Die Substratträger sind dabei derart ausgebildet, dass sie für die besonders effiziente Direkt-Plasma PECVD Technologie geeignet sind, bei der das Reaktionsplasma in unmittelbarer Nähe zu den Substraten brennt. Die Anlage verbindet die Vorteile einer Batchanlage mit Booten mit denen einer Durchlaufanlage mit flachen Substratträgern.

Durch paralleles Prozessieren mehrerer kompakter Substratträger ist die Anlagengröße skalierbar und der Durchsatz kann an die Anforderungen der Fertigungslinie angepasst werden.

Durch die Verwendung der kompakten Substratträger ist der in einer einzelnen Anlage erreichbare Durchsatz größer als bei herkömmlichen Durchlaufanlagen.

Das Anlagenkonzept ermöglicht einen modularen Aufbau, sowohl in Richtung des Materialflusses als auch quer dazu. Dies ermöglicht eine zusätzliche Senkung der Anlagen- und Betriebskosten.

Auch bei sehr hohen und bisher noch nicht realisierten Durchsätzen ist eine einfache Be- und Entladung mit herkömmlichen Verfahren möglich, was einen höheren Durchsatz bei einem kompakteren Aufbau sichert, wodurch die Kosten pro Durchsatzeinheit konstant bleiben. Zugleich wird eine einfache Beladung bei weniger Substratbruch gewährleistet, weil sämtliche Ablagepositionen für die Substrate 11 gut zugänglich sind.

Die Erfindung soll nachfolgend an einem Ausführungsbeispiel näher erläutert werden. In den zugehörigen Zeichnungen zeigen:
- Fig. 1:: schematische Darstellungen eines Substratträgers in verschiedenen Ansichten mit flach aufliegenden Substraten entsprechend dem Stand der Technik;
- Fig. 2:: eine schematische Darstellung einer Durchlaufanlage entsprechend dem Stand der Technik;
- Fig. 3 a bis h:: schematische Darstellungen von erfindungsgemäßen schmalen Substratträgern mit unterschiedlich in die Höhe gestapelten Substraten unter Nutzung der dritten Dimension;
- Fig. 4:: eine schematische Darstellung einer erfindungsgemäßen Durchlaufanlage;
- Fig. 5:: eine perspektivische Übersichtsdarstellung einer PECVD-Durchlaufanlage;
- Fig. 6:: einen Kammerdeckel mit integriertem Lampenfeld für eine Aufheizkammer;
- Fig. 7:: eine perspektivische Darstellung eines erfindungsgemäßen Bootes zur Aufnahme von sechs Stapeln von Substraten in liegender Anordnung;
- Fig. 8:: eine perspektivische Ausschnittdarstellung des Bootes nach Fig. 7 von unten mit einer Antriebseinrichtung und Plasmalanzen zur elektrischen Ankopplung;
- Fig. 9:: eine perspektivische Darstellung eines Grafit-Plasmabootes auf einem Transportrahmen mit vertikal bzw. stehend angeordneten Substraten, und
- Fig. 10:: eine perspektivische Darstellung des Transportrahmens nach Fig. 9, in den das Plasmaboot einhängbar ist.

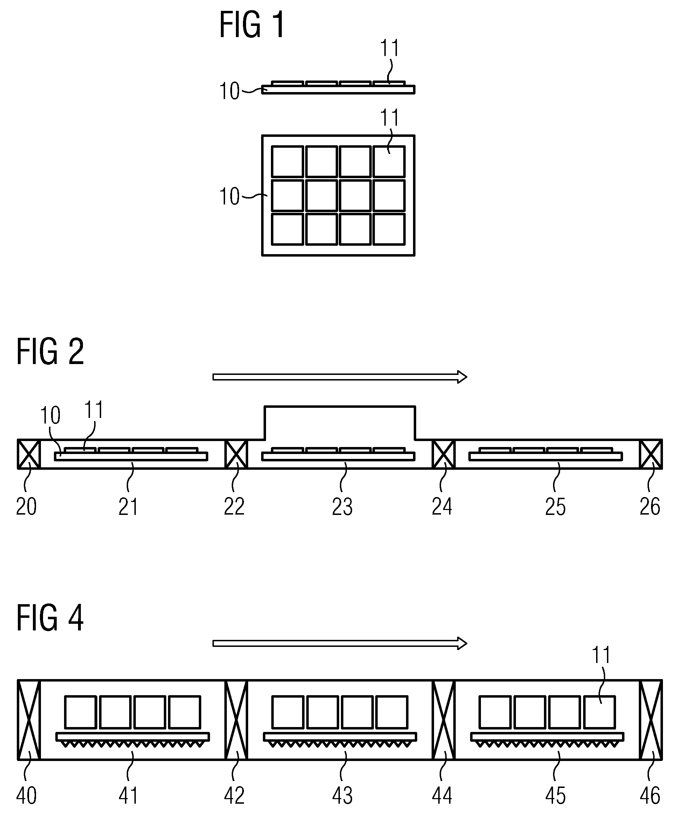

Übliche Durchlaufanlagen gemäß dem Stand der Technik für die Behandlung von Substraten bei erniedrigtem Druck bestehen gemäß Fig. 2 im einfachsten Fall aus einer Eingangsschleuse 21, einer Prozesskammer 23 und einer Austrittsschleuse 25. Die Schleusen und die Prozesskammer sind dabei üblicherweise mit vakuumdichten Schieberventilen 20, 22, 24, 26 versehen, sodass ein unabhängiges Evakuieren der Schleusen und der Prozesskammer ermöglicht wird. Es werden flache/niedrige/plattenförmige Substratträger 10 (Fig. 1, Stand der Technik) eingesetzt, auf denen flache rechteckige Substrate 11 in einer Ebene liegend, in Reihen und Spalten angeordnet sind. Zum Transport liegt der Substratträger dabei üblicherweise auf angetriebenen Rollen auf.

Der Ablauf des Durchlaufes eines Substratträgers durch die Durchlaufanlage gem. Fig. 2, Stand der Technik) erfolgt dann z.B. wie nachfolgend beschrieben.

Der Eintrittschieber 20 ist geöffnet und die Eintrittsschleuse 21 ist belüftet, die Prozesskammer 23 und die Austrittsschleuse 25 befinden sich unter erniedrigtem Druck. Der Substratträger 10 wird in die Eintrittsschleuse 21 eingefahren, der Eintrittsschieber 20 wird daraufhin geschlossen und die Eintrittsschleuse 21 evakuiert. Sobald der gleiche Druck wie in der Prozesskammer 23 erreicht ist, wird der zweite Schieber 22 geöffnet und der Substratträger 10 in die Prozesskammer 23 überführt. Der zweite Schieber 22 wird geschlossen und die Behandlung der Substrate 11 kann erfolgen.

Nach Abschluss der Behandlung wird der dritte Schieber 24 geöffnet und der Substratträger 10 wird in die Austrittsschleuse 25 überführt. Danach wird der dritte Schieber 24 geschlossen und die Austrittsschleuse 25 belüftet. Nun wird der Austrittsschieber 26 geöffnet und der Substratträger 10 kann aus der Anlage ausgefahren werden. Der Austrittsschieber 26 wird wieder geschlossen und die Austrittsschleuse 25 kann wieder evakuiert werden.

Es versteht sich, dass derartige Durchlaufanlagen nach dem Stand der Technik nur dann den ihnen zugewiesenen Zweck erfüllen, wenn sich mehrere Substratträger 10 gleichzeitig innerhalb der Anlage befinden. Der Ablauf des Durchlaufes der Substratträger 10 durch die Anlage gestaltet sich in diesem Fall komplexer als oben dargestellt.

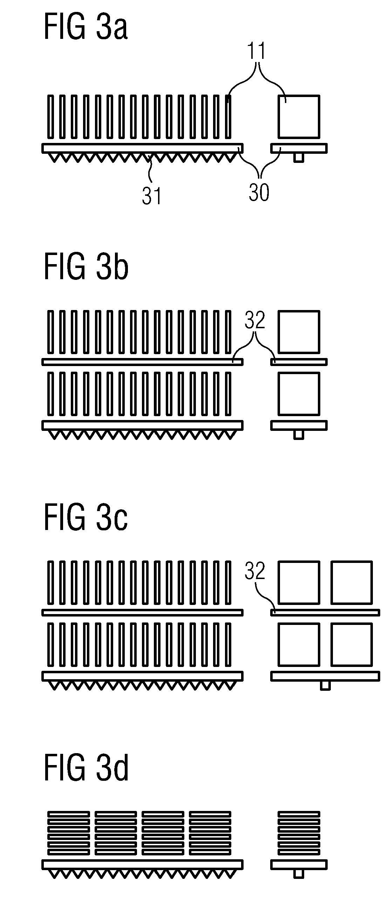

Der aus den Fig. 3a - 3h schematisch hervorgehende erfindungsgemäße Substratträger, auch als Boot bezeichnet, besteht vorzugsweise aus einer Grundplatte 30 aus einem leitfähigen Material, z.B. Graphit, auf der die Substrate 11 in einer oder mehreren Ebenen in geringem Abstand (ca. 3 bis 20 mm) in waagrechter (z.B. Fig. 3d) oder senkrechter (z.B. Fig. 3a) Anordnung stehend nebeneinander und/oder übereinander, längs oder quer zur Fahrtrichtung des Substratträgers angeordnet sind.

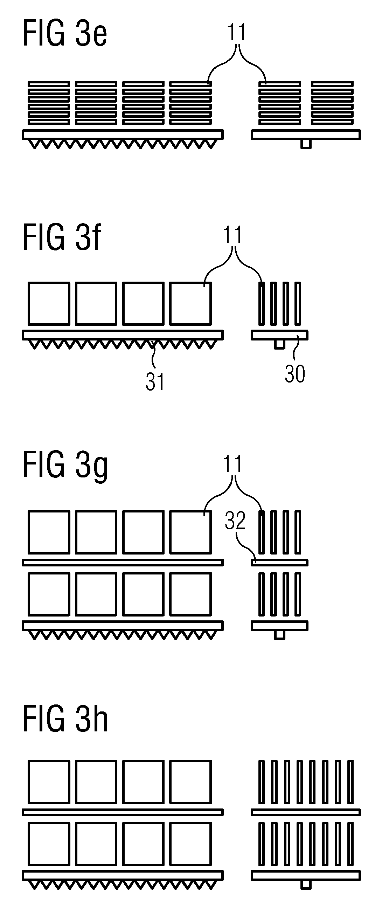

Fig. 3b, 3g zeigt die Anordnung von Substraten 11 in zwei Ebenen, wobei die Substrate 11 der oberen Lage auf einem ebenfalls aus einem leitfähigen Material, z.B. Graphit, bestehenden Zwischenträger 32 angeordnet sind.

In Fig. 3c sind jeweils zwei Reihen von Substraten 11 in zwei Ebenen angeordnet, wobei sich die oberen zwei Reihen ebenfalls auf einem Zwischenträger 32 befinden. Fig. 3h zeigt eine Variante entsprechend Fig. 3c mit verbreiterter Grundplatte 30 und verbreitertem Zwischenträger 32 zur Unterbringung von jeweils zwei Reihen von Substraten 11.

Die Substrate 11 sind gemäß Fig. 3a - 3c jeweils quer zur Fahrtrichtung und gemäß der Fig. 3f - 3g stehend längs zur Fahrtrichtung und gemäß Fig. d, e liegend angeordnet.

Es versteht sich, dass jedes Substrat 11 auf der Grundplatte 30 oder auf dem Zwischenträger 32 mittels geeigneter Haltevorrichtungen sicher gehalten werden muss, wobei ein vorgegebener Mindestabstand zwischen den Substraten nicht unterschritten werden darf, um einen ausreichenden Gasdurchsatz zu ermöglichen.

Außerdem müssen bei sämtlichen Ausführungsformen der Fig. 3 zwischen den Substraten 11 weitere Zwischenträger aus einem leitfähigen Material, z.B. Graphit, angeordnet werden, die in Verbindung mit einer geeigneten Wechselspannungszuführung als Elektroden bzw. Antennen wirken, wie noch näher auszuführen sein wird.

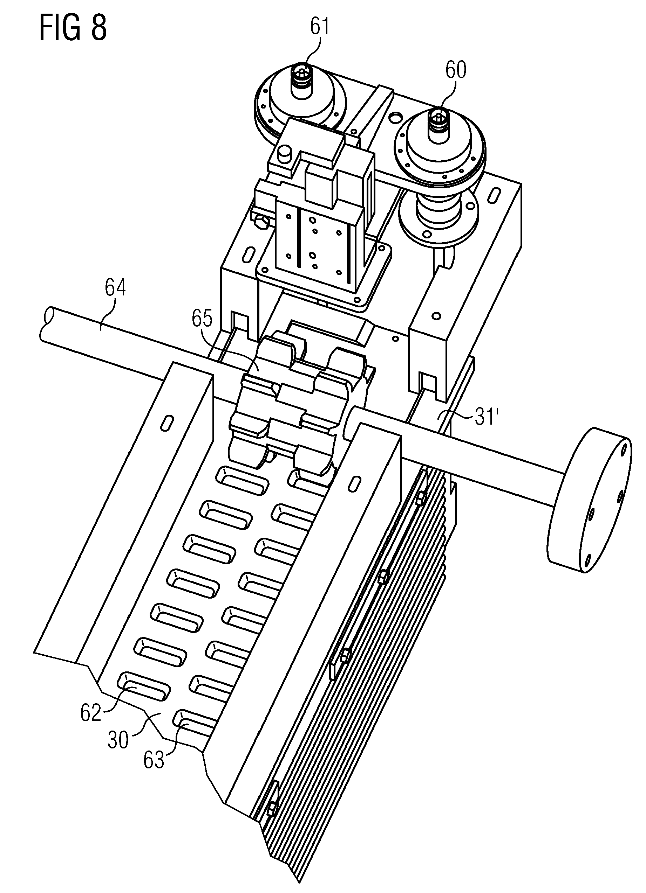

Zum Transport kann die Grundplatte 30 z.B. mit Gleitkufen 31' (Fig. 8), oder Rollen 31 ausgerüstet sein, was die Reibung erheblich vermindert. Weiterhin ist die Grundplatte 30 mit Kontakten ausgestattet, welche die Zuführung einer nieder- oder hochfrequenten Wechselspannungsleistung in kW-Bereich ermöglichen. Dazu werden dauerhaft extrem niedrige Übergangswiderstände zwischen den Kontakten und der Grundplatte sichergestellt

Durch die dreidimensionale stapelweise Anordnung der Substrate 11 auf der Grundplatte in einer oder in mehreren Etagen wird eine sehr kompakte Anordnung mit hoher Kapazität geschaffen.

Fig. 4 zeigt eine schematische Darstellung eines Beispiels für eine erfindungsgemäße Durchlaufanlage, bestehend aus drei hintereinander angeordneten Kammern, und zwar einer Aufheizkammer 41, einer nachfolgenden Prozesskammer 43 und einer Abkühlkammer 45. Den Anfang und das Ende der Durchlaufanlage bilden Vakuumschieber 40 bzw. 46, wobei zwischen der Aufheizkammer 41 und der Prozesskammer 43 sowie zwischen Prozesskammer 43 und Abkühlkammer 45 weitere Vakuumschieber 42, 44 angeordnet sind. Wenn die Prozessbedingungen in den verschiedenen Kammern nicht sehr unterschiedlich sind, müssen die Schieber nicht vakuumdicht sein, bzw. es kann in diesem Fall ggf. auf den Einsatz von Schiebern ganz verzichtet werden.

Die für den Betrieb dieser Durchlaufanlage notwendigen Vakuumpumpen und Reaktions- bzw. Spülgaszuführungen sind nicht dargestellt.

Bei einer nutzbaren Dimension der rechteckigen Grundplatte von beispielsweise 1 x 0,2 m und einer Ausführung des Substratträgers in 17 Etagen (Fig. 3c) ergibt sich bei einem Abstand der Substrate von 11 mm eine Kapazität des Substratträgers von etwa 96 Substraten der Größe 156x156 mm. Da wegen ihrer Kompaktheit mehrere Substratträger parallel prozessiert werden können, ist der Anlagendurchsatz nicht durch die Kapazität der Substratträger beschränkt.

Bei einer zweidimensional aufgebauten Plattenanlage gemäß dem Stand der Technik könnten auf derselben Fläche nur 6 Substrate untergebracht werden.

Die erfindungsgemäße Durchlaufanlage ist modular aufgebaut. In ihr durchlaufen die Substratträger einzelne Stationen deren Funktion, wie Evakuieren, Aufheizen, Vorplasma zur Oberflächenkonditionierung, Beschichtung, Abkühlen und Belüften, den Anforderungen des Prozesses angepasst werden können.

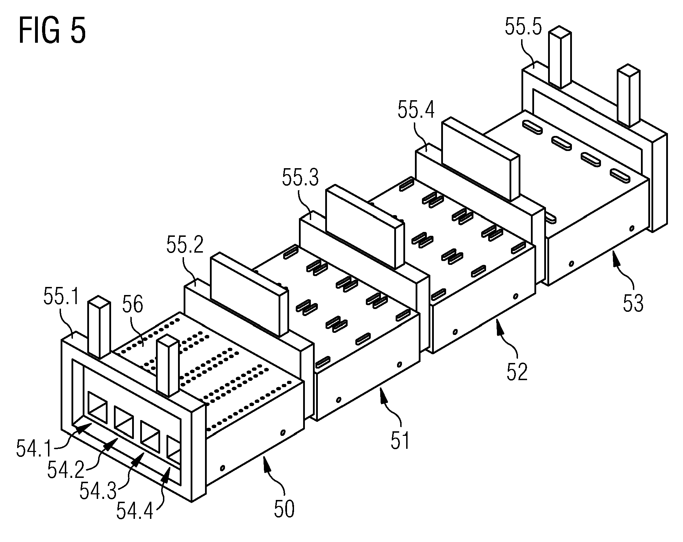

Fig. 5 zeigt eine Übersichtsdarstellung einer PECVD-Durchlaufanlage, bestehend aus einer Aufheizkammer 50, einer nachfolgenden Kammer zur Oberflächenkonditionierung 51, einer nachfolgenden Beschichtungskammer 52 und schließlich einer Abkühlkammer 53, wobei sich durch sämtliche Kammern 50, 51, 52, 53 parallel verlaufende Transportspuren 54 erstrecken, die zum Anfang und zum Ende jedes Kammersegmentes 50, 51, 52, 53 jeweils durch einen Vakuumschieber 55.1-55.5 geführt sind. Bei den Kammern 51 und 52 handelt es sich jeweils um Plasma-Bearbeitungskammern.

Grundsätzlich besteht auch die Möglichkeit, Aufheizkammer 50 mit dem zugehörigen eingangsseitigen Vakuumschieber 55.1 und die Abkühlkammer 53 mit dem zugehörigen ausgangsseitigen Vakuumschieber 55.5 jeweils zu einer Baugruppe zu kombinieren.

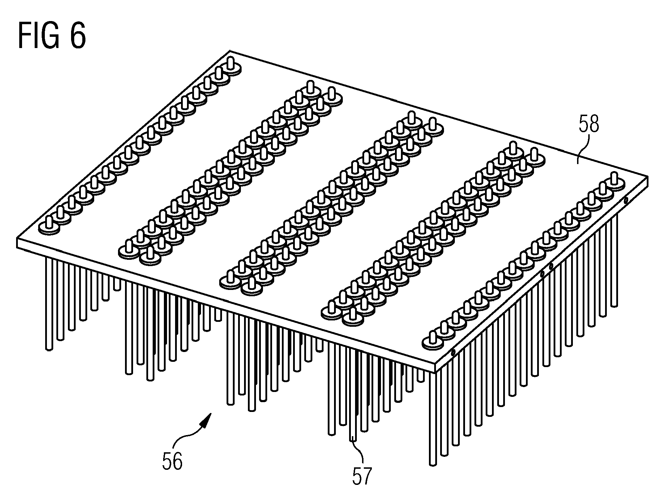

Die Aufheizkammer 50 ist zum schnellen Aufheizen der mit den Substraten 11 bestückten Plasmaboote mit einem integrierten Lampenfeld 56 für jede Transportspur 54 ausgestattet (Fig. 5, 6). Die den jeweiligen Transportspuren 54 zugeordneten Lampen 57 sind derart im Deckel 58 der Aufheizkammer 50 befestigt, dass die Boote 30 zwischen diesen eingeschoben werden können.

Es ist auch möglich, die gesamte Durchlaufanlage als Kaltwandreaktor mit integrierten Lampen auszuführen, was ein sehr schnelles Aufheizen gewährleistet. Das hat den Vorteil, dass eine Längenausdehnung der geheizten Kammern 50, 51, 52, 53 entfällt.

Es versteht sich, dass jede der Kammern der PECVD-Durchlaufanlage mit einer Einrichtung zur Erzeugung eines Vakuums in Form von Vakuumpumpen verbunden sein muss. Weiterhin kann die Abkühlkammer 53 mit einer Spülgaszuführung verbunden sein, um die Reaktionsgase vor dem Öffnen des Vakuumschiebers restlos zu entfernen.

Weiterhin sind die Kammer zur Oberflächenkonditionierung 51 und die nachfolgende Beschichtungskammer 52 mit Zuführungen für Prozess- und Spülgase verbunden.

Die Kammern 50, 51, 52, 53 können zu Wartungs- und Reinigungszwecken jeweils mit geöffnet werden, wobei die Abdichtung der Kammerdeckel mit einer O-Ring Gummidichtung erfolgen kann.

Jeder Prozessschritt kann auf zwei aufeinander folgende Stationen verteilt werden, falls der Materialfluss und die Taktzeiten das erfordern.

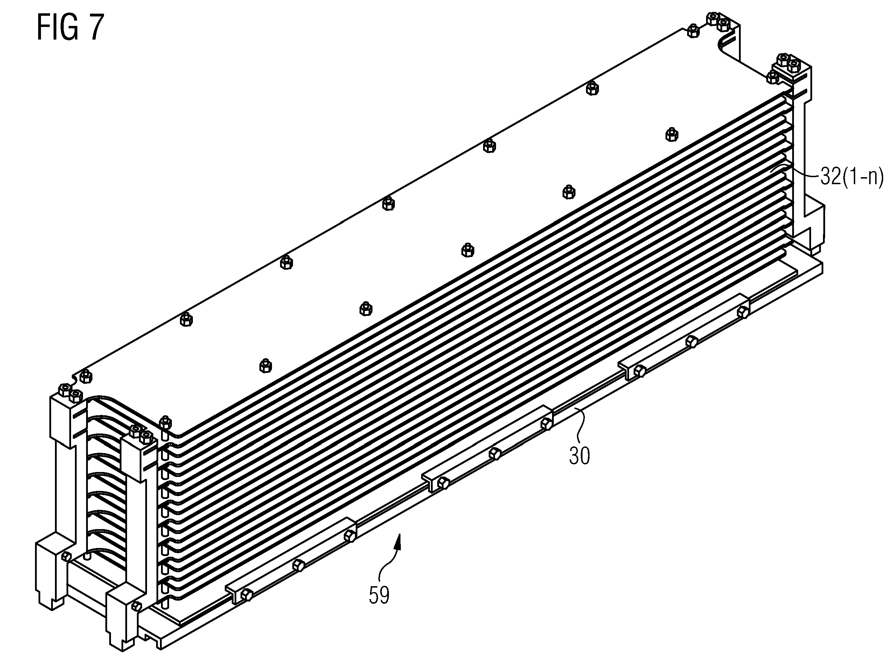

Auf Grund ihrer Kompaktheit können mehrere Boote (Grundplatten 30 ggf. mit Zwischenträger 32) parallel prozessiert werden. Fig. 7 zeigt ein Graphitboot 59 zur Aufnahme von Substraten 11 in liegender Anordnung wie in Fig. 3d schematisch dargestellt.

Die Kammern 50, 51, 52, 53 sind dafür mit der entsprechenden Anzahl von Transportspuren 54.1, 54.2, 54.3, 54.4 und einem zugehörigen Antriebssystem ausgestattet. Damit ergibt sich die Besonderheit der Erfindung, dass sich der Anlagendurchsatz vollkommen problemlos an die Anforderungen der Gesamtlinie anpassen lässt.

Das für die Beschichtung der Substrate 11 notwendige Plasma wird zwischen den sich direkt einander gegenüber liegenden Platten 32 und Substraten 11 erzeugt. Hierzu werden die sich direkt gegenüber liegenden Platten 32₍₁₋ₙ₎, einschließlich der darauf eingelegten oder befestigten Substrate 11, mit gegenpoliger Wechselspannung, üblicherweise im kHz, z.B. bei 40 kHz, oder MHz Bereich, z.B. bei 13,5 MHz oder 27 MHz, beaufschlagt (Fig. 7, 8). Somit bildet sich direkt über der Oberfläche der Substrate 11, vermittelt durch die als Elektroden fungierenden Zwischenplatten 32, ein so genanntes kapazitives Plasma aus. Das Substrat 11 selbst wird damit selbst zur Plasma erzeugenden Elektrode. In Fig. 7 besteht ein Stapel aus n=17 Substraten. Insgesamt können vier derartige Boote 30 nebeneinander gleichzeitig durch die Durchlaufanlage prozessiert werden.

Werden die Substrate 11 auf dem Plasmaboot 30 stehend angeordnet, wie aus den Fig. 3a-c und 3f-h schematisch hervor geht, brennt das Plasma zwischen den Substraten. Bei stehender Anordnung der Substrate 11 sind diese beidseits an fest auf der Grundplatte 30 stehenden Zwischenplatten 32 befestigt, so dass immer zwei Substrate 11 einander gegenüber stehen. Die Befestigung der Substrate kann hier einfach durch jeweils drei beidseits aus der Zwischenplatte 32 hervorstehende und in einem Dreieck auf der Fläche der Zwischenplatte 32 angeordnete pilzartige Pins erfolgen. Die Substrate 11 werden hier einfach hinter den pilzartigen Verdickungen eingelegt, wodurch diese jeweils an drei Punkten gesichert sind.

Je nach Zusammensetzung des Prozessgases kann das Plasma die dem Plasma zugewandte Oberfläche des Substrates 11 z.B. beschichten, reinigen, aktivieren, oxidieren, etc.

Die Zuführung der Wechselspannung an die Grundplatten 30 und die Zwischenplatten 32, also die Kontaktierung der Substratträger, erfolgt gem. Fig. 8 dergestalt, dass jede zweite Zwischenplatte 32 zum in Vorschubrichtung vorderen Ende des Bootes durchgeführt und kontaktiert ist, dadurch eine erste Antennenanordnung bildend und die dazwischen liegenden Zwischenplatten jeweils zum hinteren Ende des Bootes durchgeführt und kontaktiert sind und dadurch eine zweite Antennenanordnung bildend. Beim Anlegen einer Wechselspannung mit wechselnder Polarität wird sich dann zwischen der ersten und der zweiten Antennenanordnung, die quasi kammartig ineinander greifen, ein dem zugeführten Prozessgas entsprechendes Plasma ausbilden. Voraussetzung ist natürlich ein entsprechendes Vakuum in der Prozesskammer.

Nachdem das Plasmaboot in die Prozesskammer, z.B. die Prozesskammer zur Oberflächenkonditionierung 51, oder die Beschichtungskammer 52 eingefahren und richtig positioniert ist, wird das ruhende Plasmaboot elektrisch kontaktiert.

Dazu werden von unten z.B. vorn und hinten am Plasmaboot 30 jeweils zwei z.B. männliche HF-Kontaktstecker 60, 61, die auch als Plasma-Lanzen bezeichnet werden können. nach oben in entsprechende Buchsen (nicht dargestellt) im Boot 30 mittels eines geeigneten Stellantriebes eingeführt (Fig. 8), wodurch gleichzeitig das Boot 30 an Ort und Stelle fixiert wird.

Die HF-Kontaktstecker 60, 61 stellen die elektrische Verbindung zwischen den entsprechenden Platten 32 des Plasmabootes 30 und einer Wechselspannungsversorgung her. Unter der Voraussetzung, dass innerhalb der Prozesskammer ein oder mehrere Prozessgase in ausreichender Konzentration vorhanden sind, wird, nachdem die Wechselspannung zugeschaltet ist, sich ein Plasma zwischen den Platten ausbilden. Nachdem der Prozess beendet ist, wird die Wechselspannung ausgeschaltet, die HF-Kontaktstecker 60, 61 zurückgezogen und das Boot 30 kann zur nächsten Station weiter transportiert werden.

Einzelheiten der Transporteinrichtung für die Boote 30 in den einzelnen Kammern 50, 51, 52, 53 sind aus Fig. 8 ersichtlich. Die Grundplatten 30 sind auf der Unterseite mit in zwei Spuren angeordneten Vertiefungen 62, 63 versehen, in welche die Zähne eines auf einer Antriebswelle 64 befindlichen Zahnrades 65 eingreifen.

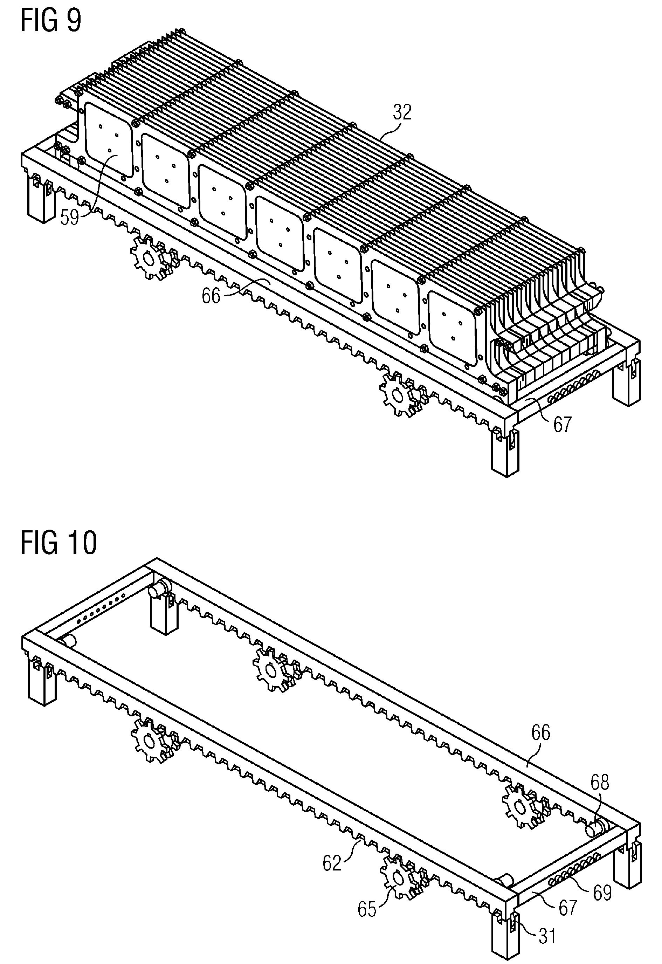

In den Fig. 9 und 10 ist eine weitere Ausführungsform der Erfindung dargestellt, bei der die Substrate in vertikal angeordneten Zwischenträgern 32 in Form von Substratträger-Platten auf einem aus Graphit bestehenden Plasmaboot 59 angeordnet sind.

Das Plasmaboot 59 ist gemäß Fig. 9 in einem Transportrahmen räumlich fixiert, wobei der Transportrahmen aus miteinander verbundenen Längs- und Querholmen 66, 67 besteht. Dieser Transportrahmen ist in Fig. 10 in seinen Einzelheiten dargestellt. Der Transportrahmen umschließt eine Fläche, die ausreichend ist, dass das Plasmaboot 59 in diesen eintauchen kann, so dass das Plasmaboot 59 vom Transportrahmen formschlüssig umgeben wird.

Innerhalb der Umgrenzung des durch die Längs- und Querholme 66, 67 gebildeten Transportrahmens befinden sich in den Eckbereichen elektrisch isolierte Bootsauflagen 68, so dass das Plasmaboot 59 beim Einsetzen und auch beim horizontalen Weitertransport durch die Durchlaufanlage wie in Fig. 4 schematisch dargestellt, durch dessen Eigengewicht sicher gehalten wird, so wie aus Fig. 9 ersichtlich ist. Die elektrische Kontaktierung des Graphitbootes 59 zur Erzeugung des notwendigen Plasmas erfolgt bei der Anordnung nach Fig. 9 ähnlich wie in Fig. 7 bzw. in der zugehörigen Beschreibung dargestellt.

Die notwendigen elektrischen Kontaktelemente sind in Fig. 9 am rechten vorderen Ende ersichtlich.

Weiterhin ist aus Fig. 9 und 10 zu erkennen, dass die beiden parallel zueinander angeordneten Längsholme 66 auf deren Unterseite mit regelmäßig verteilten Vertiefungen 62 bzw. Zähnen, vergleichbar mit einer Zahnstange, ausgestattet sind, in die Zahnräder 65 eingreifen, so dass in Verbindung mit einem entsprechenden Antrieb ein Transport des Transportrahmens mit dem Graphitboot 59 durch eine Durchlaufanlage ermöglicht wird, wie in Fig. 4 schematisch dargestellt ist. Um ein Abkippen des Transportrahmens während des Transportes zu verhindern, sind in Abständen Rollen 31 oder Gleitschienen vorgesehen, auf denen der Transportrahmen horizontal in Verbindung mit den Zahnrädern 65 sicher durch die Durchlaufanlage geführt wird.

Weiterhin ist der Transportrahmen mit Codierstiften 69 versehen, die wahlweise eingesetzt oder entfernt werden können und durch Abtasten nach einem üblichen Verfahren die Erkennung des Grafitbootes 59 mit Hilfe eine Binärzahl ermöglichen.

### Bezugszeichenliste

- 10: Substratträger
- 11: Substrat
- 20: Schieberventil
- 21: Eintrittsschleuse
- 22: Schieberventil
- 23: Prozesskammer
- 24: Schieberventil
- 25: Austrittsschleuse
- 26: Schieberventil
- 30: Grundplatte/Plasmaboot
- 31: Rollen
- 31': Gleitschiene
- 32: Zwischenträger
- 40: Vakuumschieber
- 41: Aufheizkammer
- 42: Vakuumschieber
- 43: Prozesskammer
- 44: Vakuumschieber
- 45: Abkühlkammer
- 46: Vakuumschieber
- 50: Aufheizkammer
- 51: Kammer zur Oberflächenkonditionierung
- 52: Belichtungskammer
- 53: Abkühlkammer
- 54: Transportspur
- 55: Vakuumschieber4
- 56: Lampenfeld
- 57: Lampe
- 58: Deckel
- 59: Plasmaboot
- 60: HF-Kontaktstecker
- 61: HF-Kontaktstecker
- 62: Vertiefung
- 63: Vertiefung
- 64: Antriebswelle
- 65: Zahnrad
- 66: Längsholm
- 67: Querholm
- 68: Bootsauflage
- 69: Codierungsstift

## Patentansprüche

1. Vakuum-Durchlaufanlage zur Prozessierung von Substraten (11) mit einer Eintritts- (21) und einer Austrittsschleuse (25) sowie mindestens einer Prozesskammer (23, 43), sowie einer Einrichtung zum Transport der Substrate durch die Durchlaufanlage, wobei die Einrichtung zum Transport der Substrate (11) durch die Durchlaufanlage hindurch mindestens ein Plasmaboot (30, 59) aufweist, bei dem die Substrate (11) in dreidimensionaler Stapelung in mindestens einer Ebene in einem vorgegebenen Abstand zueinander unter Zwischenlage von Zwischenträgern (32) auf einer Grundplatte (30) angeordnet sind, **dadurch gekennzeichnet, dass** zumindest die Zwischenträger (32) aus einem elektrisch leitfähigen Material bestehen und über elektrische Verbindungsmittel mit einer Wechselspannung elektrisch beaufschlagbar sind, so dass die Zwischenträger (32) als Elektroden beziehungsweise Antennen wirken.

2. Vakuum-Durchlaufanlage nach Anspruch 1, **dadurch gekennzeichnet, dass** die Substrate (11) einer Ebene in waagrechter Stapelanordnung oder in senkrechter Anordnung stehend auf einer Grundplatte (30) des Plasmabootes (30, 59) angeordnet sind.

3. Vakuum-Durchlaufanlage nach Anspruch 1 und 2, **dadurch gekennzeichnet, dass** die Substrate (11) jeder weiteren Ebene jeweils auf einem Zwischenträger (32) angeordnet sind, der sich mit Abstand zur Grundplatte des Plasmabootes (30, 59) auf dieser befindet.

4. Vakuum-Durchlaufanlage nach Anspruch 3, **dadurch gekennzeichnet, dass** die Substrate (11) in mindestens zwei Ebenen angeordnet sind.

5. Vakuum-Durchlaufanlage nach einem der Ansprüche 1 bis 4, **dadurch gekennzeichnet, dass** die Substrate (11) in mindestens zwei Reihen nebeneinander auf der Grundplatte des Plasmabootes (30, 59) angeordnet sind.

6. Vakuum-Durchlaufanlage nach einem der Ansprüche 1 bis 5, **dadurch gekennzeichnet, dass** die Substrate (11) in jeder Ebene in mindestens zwei Reihen angeordnet sind.

7. Vakuum-Durchlaufanlage nach einem der Ansprüche 1 bis 6, **dadurch gekennzeichnet, dass** die Grundfläche der Grundplatte des Plasmabootes (30, 59) bzw. der Zwischenplatten (32) 1 m x 0,2 m beträgt.

8. Vakuum-Durchlaufanlage nach einem der Ansprüche 1 bis 7, **dadurch gekennzeichnet, dass** der Abstand der Substrate (11) zueinander ca. 3-20 mm beträgt.

9. Vakuum-Durchlaufanlage nach einem der Ansprüche 1 bis 3, **dadurch gekennzeichnet, dass** die Substrate (11) beidseits an fest auf der Grundplatte des Plasmabootes (30, 59) stehenden Zwischenplatten (32) befestigt, derart, dass immer zwei Substrate (11) einander gegenüber befinden.

10. Vakuum-Durchlaufanlage nach Anspruch 9, **dadurch gekennzeichnet, dass** zur Befestigung der Substrate (11) jeweils drei beidseits aus der Fläche der Zwischenplatte (32) hervorstehende und in einem Dreieck angeordnete pilzartige Pins vorgesehen sind, wobei die Substrate (11) hinter den pilzartigen Verdickungen räumlich fixiert sind.

11. Vakuum-Durchlaufanlage nach einem der Ansprüche 1 bis 10, **dadurch gekennzeichnet, dass** mindestens zwei Plasmaboote (30, 59) nebeneinander und/oder übereinander durch die Durchlaufanlage fahrbar sind.

12. Vakuum-Durchlaufanlage nach einem der Ansprüche 1 bis 10, **dadurch gekennzeichnet, dass** die Grundplatte des Plasmabootes (30, 59) mit Gleitkufen ausgerüstet ist.

13. Vakuum-Durchlaufanlage nach einem der Ansprüche 1 bis 10, **dadurch gekennzeichnet, dass** die Grundplatte des Plasmabootes (30, 59) mit Rollen (31) ausgestattet ist.

14. Vakuum-Durchlaufanlage nach einem der Ansprüche 1 bis 10, **dadurch gekennzeichnet, dass** das Plasmaboot (59) in einem Transportrahmen fixiert ist, der aus miteinander verbundenen Längs- und Querholmen (66, 67) besteht und dass die Längsholme (66) des Transportrahmens auf der Unterseite mit regelmäßigen Vertiefungen (62) bzw. Zähnen ausgestattet sind, in die Zahnräder (65) zum horizontalen Transport des Transportrahmens mit dem darin befindlichen Graphitboot (59) eingreifen.

15. Vakuum-Durchlaufanlage nach Anspruch 14, **dadurch gekennzeichnet, dass** der Transportrahmen das Graphitboot (59) außen formschlüssig umschließt, derart, dass das Graphitboot (59) auf in den Eckbereichen des Transportrahmens befindliche Bootsauflagen (68) aufsetzbar ist.

16. Vakuum-Durchlaufanlage nach Anspruch 15, **dadurch gekennzeichnet, dass** die Bootsauflagen (68) gegenüber dem Transportrahmen elektrisch isoliert sind.

17. Vakuum-Durchlaufanlage nach einem der Ansprüche 1 bis 8, **dadurch gekennzeichnet, dass** jede zweite Zwischenplatte 32 zu einem Fußpunkt des Bootes durchgeführt und kontaktiert ist, eine erste Antennenanordnung bildend, und die dazwischen liegenden Zwischenplatten (32) jeweils zu einem zweiten Fußpunkt Bootes durchgeführt und kontaktiert, eine zweite Antennenanordnung bildend, und über die elektrischen Verbindungsmittel mit Zuführungen für Wechselspannung zur Ausbildung eines Plasmas zwischen der ersten und der zweiten Antennenanordnung verbunden sind.

18. Vakuum-Durchlaufanlage nach einem der Ansprüche 1 bis 14, **dadurch gekennzeichnet, dass** die elektrischen Verbindungsmittel in Form von männlichen HF-Kontaktsteckern (60, 61) ausgebildet sind, welche zumindest die Zwischenplatten (32) über geeignete Stromverteilerschienen kontaktieren.

19. Vakuum-Durchlaufanlage nach Anspruch 18, **dadurch gekennzeichnet, dass** die HF-Kontaktstecker (60, 61) mittels eines Stellantriebes verfahrbar sind.

20. Vakuum-Durchlaufanlage nach einem der Ansprüche 1 bis 19, **dadurch gekennzeichnet,** die Einrichtung zum Transport der Substrate (11) durch die Durchlaufanlage hindurch eine Mehrzahl von parallelen Transportspuren (54) zum gleichzeitigen parallelen Transport mehrerer Plasmaboote (30, 59) umfasst.

21. Vakuum-Durchlaufanlage nach Anspruch 20, **dadurch gekennzeichnet, dass** sich die Transportspuren kanalförmig durch die Durchlaufanlage erstrecken.

## Claims

1. A continuous vacuum system for processing substrates (11), comprising an inlet air lock (21) and an outlet air lock (25) and at least one process chamber (23, 43), as well as a device for conveying the substrates through the continuous system, wherein the device for conveying the substrates (11) through the continuous system has at least one plasma boat (30, 59) in which the substrates (11) are arranged on a base plate (30) in a three-dimensional stack in at least one plane at a predetermined distance from one another with intermediate carriers (32) in between,
**characterized in that**
at least the intermediate carriers (32) are made of an electrically conductive material and can be acted upon electrically via electric connecting means with an alternating voltage, so that the intermediate carriers (32) act as electrodes and/or antennas.

2. The continuous vacuum system according to Claim 1,
**characterized in that**
the substrates (11) of a plane are arranged in a horizontal stack arrangement or in a vertical arrangement upright on a base plate (30) of the plasma boat (30, 59).

3. The continuous vacuum system according to Claims 1 and 2,
**characterized in that**
the substrates (11) of each additional plane are each arranged on the intermediate carrier (32), which is on the base plate of the plasma boat (30, 59) with a distance from the latter.

4. The continuous vacuum system according to Claim 3,
**characterized in that**
the substrates (11) are arranged in at least two planes.

5. The continuous vacuum system according to any one of Claims 1 to 4,
**characterized in that**
the substrates (11) are arranged in at least two rows side by side on the base plate of the plasma boat (30, 59).

6. The continuous vacuum system according to any one of Claims 1 to 5,
**characterized in that**
the substrates (11) are arranged in at least two rows in each plane.

7. The continuous vacuum system according to any one of Claims 1 to 6,
**characterized in that**
the base area of the base plate of the plasma boat (30, 59) and/or the intermediate plates (32) is 1 m x 0.2 m.

8. The continuous vacuum system according to any one of Claims 1 to 7,
**characterized in that**
the distance of the substrates (11) from one another is approximately 3 - 20 mm.

9. The continuous vacuum system according to any one of Claims 1 to 3,
**characterized in that**
the substrates (11) are attached on both sides to intermediate plates (32)standing fixedly on the base plate of the plasma boat (30, 59), such that two substrates (11) are always opposite one another.

10. The continuous vacuum system according to Claim 9,
**characterized i n that**
for fastening the substrates (11) three mushroom-shaped pins that protrude out of the surface of the intermediate plate (32)on both sides and are arranged in a triangle are provided, whereby the substrates (11) are secured spatially behind the mushroom-shaped pins.

11. The continuous vacuum system according to any one of Claims 1 to 10,
**characterized in that**
at least two plasma boats (30, 59) can be run side by side and/or one above the other through the continuous system.

12. The continuous vacuum system according to any one of Claims 1 to 10,
**characterized i n that**
the base plate of the plasma boat (30, 59) is equipped with sliding blocks.

13. The continuous vacuum system according to any one of Claims 1 to 10,
**characterized in that**
the base plate of the plasma boat (30, 59) is equipped with rollers (31).

14. The continuous vacuum system according to any one of Claims 1 to 10,
**characterized in that**
the plasma boat (59) is secured in a conveyer frame which is made of interconnected longitudinal and transverse struts (66, 67) and the longitudinal struts (66) of the conveyor frame are equipped with regular recesses (62) and/or teeth on the underside, meshing in the gearwheels (65) for horizontal conveyance of the conveyor frame with the graphite boat (59) situated therein.

15. The continuous vacuum system according to Claim 14,
**characterized in that**
the conveyor frame surrounds the graphite boat (59) in a form-fitting manner on the outside such that the graphite boat (59) can be placed onto boat supports (68) provided in the corner areas of the conveyor frame.

16. The continuous vacuum system according to Claim 15,
**characterized in that**
the boat supports (68) are electrically insulated with respect to the conveyor frame.

17. The continuous vacuum system according to any one of Claims 1 to 8,
**characterized in that**
every second intermediate plate (32) is passed through and contacted with a base point of the boat, forming a first antenna arrangement, and the intermediate plates (32) in between are each passed through and contacted with a second base point of the boat, forming a second antenna arrangement, and are connected via the electric connecting means to supply lines for alternating voltage to form a plasma between the first and second antenna arrangements.

18. The continuous vacuum system according to any one of Claims 1 to 14,
**characterized in that**
the electric connection means are embodied in the form of male HF contact plugs (60, 61) which contact at least the intermediate plates (32) via suitable current distribution busbars.

19. The continuous vacuum system according to Claim 18,
**characterized in that**
the HF contact plugs (60, 61) are movable by means of an actuator drive.

20. The continuous vacuum system according to any one of Claims 1 to 19,
**characterized in that**
the device for conveying the substrates (11) through the continuous system comprises a plurality of parallel conveyor lines (54) for simultaneous parallel conveyance of multiple plasma boats (30, 59).

21. The continuous vacuum system according to Claim 20,
**characterized in that**
the conveyor lines extend in the form of a channel through the continuous system.

## Revendications

1. Installation de passage sous vide pour le traitement de substrats (11) avec un sas d'entrée (21) et un sas de sortie (25) ainsi qu'au moins une chambre de traitement (23, 43) et ainsi qu'un dispositif pour le transport des substrats à travers l'installation de passage, cependant que le dispositif pour le transport des substrats (11) à travers l'installation de passage présente au moins un bateau de plasma (30, 59) pour lequel les substrats (11) sont placés dans un empilage tridimensionnel dans au moins un plan à une distance prédéfinie l'un par rapport à l'autre en intercalant des supports intermédiaires (32) sur une plaque de base (30), **caractérisée en ce qu'**au moins les supports intermédiaires (32) sont en un matériau conducteur électrique et peuvent être sollicités électriquement par une tension alternative par des moyens de connexion électriques si bien que les supports intermédiaires (32) agissent comme des électrodes ou des antennes.

2. Installation de passage sous vide selon la revendication 1, **caractérisée en ce que** les substrats (11) d'un plan sont placés en un arrangement empilé horizontal ou en un arrangement vertical en étant debout sur une plaque de base (30) du bateau de plasma (30, 59).

3. Installation de passage sous vide selon la revendication 1 ou 2, **caractérisée en ce que** les substrats (11) de chaque autre plan sont placés respectivement sur un support intermédiaire (32) qui se trouve à une distance de la plaque de base du bateau de plasma (30, 59).

4. Installation de passage sous vide selon la revendication 3, **caractérisée en ce que** les substrats (11) sont placés dans au moins deux plans.

5. Installation de passage sous vide selon l'une des revendications 1 à 4, **caractérisée en ce que** les substrats (11) sont placés dans au moins deux rangées l'une à côté de l'autre sur la plaque de base du bateau de plasma (30, 59).

6. Installation de passage sous vide selon l'une des revendications 1 à 5, **caractérisée en ce que** les substrats (11) sont placés dans chaque plan dans au moins deux rangées.

7. Installation de passage sous vide selon l'une des revendications 1 à 6, **caractérisée en ce que** la surface de base de la plaque de base du bateau de plasma (30, 59) ou des plaques intermédiaires (32) est de 1 m x 0,2 m.

8. Installation de passage sous vide selon l'une des revendications 1 à 7, **caractérisée en ce que** la distance des substrats (11) l'un par rapport à l'autre est d'environ 3 à 20 mm.

9. Installation de passage sous vide selon l'une des revendications 1 à 3, **caractérisée en ce que** les substrats (11) sont fixés des deux côtés à des plaques intermédiaires (32) se trouvant fixes sur la plaque de base du bateau de plasma (30, 59) de telle manière que toujours deux substrats (11) se trouvent l'un en face de l'autre.

10. Installation de passage sous vide selon la revendication 9, **caractérisée en ce que** respectivement trois broches de type champignon faisant saillie des deux côtés de la surface de la plaque intermédiaire (32) et placées en un triangle sont prévues pour la fixation des substrats (11), cependant que les substrats (11) sont fixés derrière les épaississements de type champignon.

11. Installation de passage sous vide selon l'une des revendications 1 à 10, **caractérisée en ce qu'**au moins deux bateaux de plasma (30, 59) sont mobiles à travers l'installation de passage l'un à côté de l'autre et/ou l'un au-dessus de l'autre.

12. Installation de passage sous vide selon l'une des revendications 1 à 10, **caractérisée en ce que** la plaque de base du bateau de plasma (30, 59) est équipée de patins.

13. Installation de passage sous vide selon l'une des revendications 1 à 10, **caractérisée en ce que** la plaque de base du bateau de plasma (30, 59) est équipée de rouleaux (31).

14. Installation de passage sous vide selon l'une des revendications 1 à 10, **caractérisée en ce que** le bateau de plasma (59) est fixé dans un cadre de transport qui est constitué par des longerons et des traverses (66, 67) et que les longerons (66) du cadre de transport sont équipés, sur la face inférieure, d'encoches régulières (62) ou de dents dans lesquelles les roues dentées (65) s'engrènent pour le transport horizontal du cadre de transport avec le bateau de graphite qui s'y trouve (59).

15. Installation de passage sous vide selon la revendication 14, **caractérisée en ce que** le cadre de transport enserre le bateau de graphite (59) à l'extérieur de manière crabotée de telle manière que le bateau de graphite (59) peut être posé sur des appuis pour bateau (68) qui se trouvent dans les zones d'angle du cadre de transport.

16. Installation de passage sous vide selon la revendication 15, **caractérisée en ce que** les appuis pour bateau (68) sont isolés électriquement du cadre de transport.

17. Installation de passage sous vide selon l'une des revendications 1 à 8, **caractérisée en ce que** chaque deuxième plaque intermédiaire (32) traverse jusqu'à un point de base du bateau et est en contact avec celui-ci en formant un premier arrangement d'antenne et les plaques intermédiaires situées entre celles-ci (32) traversent respectivement jusqu'à un second point de base du bateau et sont contact avec celui-ci en formant un second arrangement d'antenne et sont reliées par les moyens de connexion électriques à des arrivées de tension alternative pour configurer un plasma entre le premier et le second arrangement d'antenne.

18. Installation de passage sous vide selon l'une des revendications 1 à 14, **caractérisée en ce que** les moyens de connexion électriques sont configurés en forme de bornes de contact HF mâles (60, 61) qui mettent en contact au moins les plaques intermédiaires (32) par des rails de distribution électrique appropriés.

19. Installation de passage sous vide selon la revendication 18, **caractérisée en ce que** les bornes de contact HF (60, 61) peuvent être déplacées au moyen d'un servomoteur,

20. Installation de passage sous vide selon l'une des revendications 1 à 19, **caractérisée en ce que** le dispositif pour le transport des substrats (11) à travers l'installation de passage comprend une multitude de voies de transport parallèles (54) pour le transport parallèle simultané de plusieurs bateaux de plasma (30, 59).

21. Installation de passage sous vide selon la revendication 20, **caractérisée en ce que** les voies de transport s'étendent en forme de canal à travers l'installation de passage.
